# EUROPÄISCHE PATENTSCHRIFT

(11) **EP 1 789 809 B1**
(45) Veröffentlichungstag und Bekanntmachung des Hinweises auf die Patenterteilung: **17.11.2010**
(21) Anmeldenummer: 05771355.4
(22) Anmeldetag: 22.08.2005
(51) Int. Cl.: G01R 22/00, G01R 11/04, H05K 5/02

(54) **ELEKTRISCHES GERÄT MIT MODULANSCHLUSSMÖGLICHKEIT**
ELECTRIC DEVICE WITH MODULAR CONNECTION POSSIBILITIES
APPAREIL ELECTRIQUE PRESENTANT UNE POSSIBILITE DE CONNEXION DE MODULE

(30) Priorität: 23.08.2004 DE 102004040916
(43) Veröffentlichungstag der Anmeldung: 30.05.2007
(73) Patentinhaber: Landis+Gyr AG, 6300 Zug (CH)
(72) Erfinder: SCHAUB, Thomas, CH-6330 Cham (CH); DEAN, Michael, Oldham OL9 8DW (GB); MEGNET, Rolf, CH-6430 Goldau (CH); MÜLLER, Peter, Bourne PE 10 98A (GB)
(74) Vertreter: Rentsch & Partner
(86) Internationale Anmeldenummer: PCT/CH2005/000490
(87) Internationale Veröffentlichungsnummer: WO 2006/021119

(56) Entgegenhaltungen:
- EP-A- 0 947 836
- EP-A- 0 961 122
- EP-A- 1 102 072
- WO-A-98/54583
- US-B1- 6 226 600

## Beschreibung

Die Erfindung stammt aus dem technischen Gebiet der elektrischen Geräte. Sie betrifft ein elektrisches Gerät mit Modulanschlussmöglichkeit.

Elektrische Geräte zeigen üblicherweise eine ihrem Einsatzort spezifische Installation auf. Dabei kommen sowohl Installationstelle des elektrischen Geräts zum Einsatz, die als Grundfunktionsteil des elektrischen Geräts bezeichnet werden und somit an jedem Einsatzort vorhanden sein müssen. Darüber hinaus bedarf es in dem elektrischen Gerät zumeist einem oder mehrerer Zusatzfunktionsteile, kurz: Zusatzmodule, die das elektrische Gerät zusammen mit dem Grundfunktionsteil für den besonderen Einsatzort individualisieren.

Das elektrische Gerät ist jedenfalls auch in seiner Grundausstattung mit dem Grundfunktionsteil voll funktionstüchtig. Ein Zusatzmodul erweitert lediglich die Funktionspalette am Einsatzort oder sogar in der Ferne. Dies bedeutet, das eine Vielzahl von Zusatzmodulen unterschiedlichste Funktionen ausüben können. Solche Zusatzfunktionen ergänzen entweder die Grundfunktionen des elektrischen Geräts unmittelbar am Einsatzort, z.B. mittels Berechungsmodulen oder Anzeigemodulen, oder das Zusatzmodul übernimmt Kommunikationsfunktionen mit der Umgebung. Solche Zusatzmodule mit Kommunikationsfunktionen sind beispielsweise bekannt als leitungsgebundene Sende- bzw. Empfangsmodule oder als Kommunikationsmodute mit einer irgendwie gearteten drahtlosen Übertragung, wie ein GSM-Modul oder ein Funkmodul.

Zunehmend an Bedeutung gewinnen die Ausgestaltungwünsche elektrischer Geräte mit Grundfunktion an ihrem Einsatzort Deshalb sind elektrische Geräte bekannt, die ein hohes Mass an Flexibilität aufweisen, um auf einfache Weise an die Bedingungen ihres Einsatzortes angepasst werden zu können.

Beispielhaft sei hier auf die EP 0 961 122 A1 verwiesen, in welcher Elektrizitätszähler dargestellt sind, die mittels Zusatzmodulen verschiedenster Art ausgestattet werden können. Die Zusatzmodule weisen dabei zumindest eine Kommunikationsschnittstelle auf, über die sie mit einem Grttndfunktionsteil des Elektrizitätszählers Daten und/oder Impulse und/oder analoge/digitale Ein- bzw. Ausgänge im Einwegverfahren oder Zweiwegverfahren austauschen. Solche Zusatzmodule sind entweder autark, dass heisst, sie benötigen keine oder benutzen eine eigenen Energiequelle (Batterie) bei der Furiktionsausübung, oder aber sie bedürfen einer Speisung von aussen.

Die EP 0 961 122 A1 zeigt Zusatzmodule die als Speisung von aussen eine Gleichstromversorgung haben. Diese Glelchstromversorgung erfolgt unmittelbar vom Basiszähler aus, dass heisst im Grundfunktionsteil des Elektrizitätszählers ist ein Netzteil so ausgelegt, dass es ein Zusatzmodul ebenfalls mit Gleichstrom versorgen kann. Die Kontaktierung der Gleichstromversorgung erfolgt beim Einstecken des Zusatzmoduls in den Elektrizitätszähler.

Diese zusätzliche Nutzung eines Elektrizitätszähler-Netzteils auch für ein Zusatzmodul ist lediglich begrenzt möglich. Den Rahmen bilden die Betriebsparameter des Netzteils. Wenn ein Zusatzmodul aber mehr Versorgungsenergie benötigt, als das Netzteil des Zählers liefern kann, muss ein solches Zusatzmodul mittels entsprechend verlegter Leitungen an die Wechselstromklemmen des Zählers angeschlossen werden. Dann beherbergt ein solches Zusatzmodul neben den Zusatzfunktionsteilen ein eigenes Netzteil für die Energiebereitstellung. Herkömmliche Elektrizitätszähler und die Zusatzmodule mit eigenem Netzanschluss und Netzteil können somit nicht im Stile des "Plug and Play" zu Einsatz gelangen, das heisst, die Zusatzmodule bedürfen nach einem Einsetzen in den Elektrizitätszähler eine besondere Verdrahtung zum Netzanschluss und sind nicht unmittelbar funktionsfähig nach dem Einsetzen.

In der WO 03/012462 A1 ist ein Zusatzmodul zu einem elektrischen Gerät offenbart, bei welchem eine Kontaktierung des Zusatzmoduls über einen Stecker mit mehreren Kontakten bereitgestellt wird. Das Zusatzmodul wird hierdurch mit Stromsignalen und Spannungssignalen eines Verbrauchers versorgt, um diese einer Auswertung zuführbar zu machen.

Ausgehend vom gattungsgemässen Stand der Technik liegt der Erfindung deshalb die Aufgabe zugrunde, ein elektrisches Gerät bereitzustellen, das unabhängig vom Energiebedarf und der Energieart eines für den Einsatzort bestimmten Zusatzmoduls eine sofortige Funktionalität des Zusatzmoduls nach Einstecken desselben in das elektrische Gerät ermöglicht (Plug and Play).

Erfindungsgemäss wird diese Aufgabe durch die Merkmale des Anspruchs 1 gelöst. Weitere vorteilhafte Ausgestaltungen der Erfindung sind Gegenstand der abhängigen Ansprüche 2 bis 8.

Zur Lösung der der Erfindung zugrunde liegenden Aufgabe ist bei einem elektrischen Gerät vorgesehen, neben einer Kommunikationsschnittstelle für Daten und/oder Impulse und/oder analoge/digitale Ein- bzw. Ausgänge mindestens eine Gleichstromversorgung (begrenzt) und eine Wechselstromversorgung unmittelbar aus dem elektrischen Gerät heraus einem beliebigen Zusatzmodul so zur Verfügung zu stellen, so dass beim Einsetzen dieses Zusatzmoduls in das elektrische Gerät eine sofortige Verbindung mit der Kommunikationsschnittstelle hergestellt wird und darüber hinaus bedarfsweise eine Kontaktierung mit der Gleichstromversorgung bzw. der Wechselstromversorgung erfolgt nach dem Prinzip des "Plug and Play".

Erfindungsgemäss wird somit erstmalig ein elektrisches Gerät zur Verfügung gestellt, dass für jedes beliebige Zusatzmodul ein Basisgerät sein kann. Dabei ist nun unerheblich, ob das Zusatzmodul autark ist, dass heisst selbst versorgend, oder eine Gleichstromversorgung benötigt, bzw. eine Wechselstromversorgung. In jedem Fall stellt das efindungsgemässe elektrische Gerät neben einer standardisierten Kommunikationsschnittstelle in einer Ausnehmung zur Aufnahme eines beliebigen Zusatzmoduls eine Gleichstromversorgung und eine Wechselstromversorgung jeweils über geeignete Anschlüsse zur Verfügung.

Somit ist das neue elektrische Gerät offen für jedes beliebige Zusatzmodul und kann je nach Funktionsbedarf am Einsatzort individualisiert werden, und dass über die gesamte Einsatzdauer des elektrischen Geräts. Späteren Funktionswechseln oder Funktionsergänzungen steht während der Lebensdauer des elektrischen Geräts nun nichts mehr im Wege. Auch für einen neuen, heute noch nicht definierten Funktionsbedarf ist das erfindungsgemässe elektrische Gerät bereits heute gewappnet.

Mit Vorteil umfasst ein zu dem elektrischen Gerät besonders geeignetes Zusatzmodul eine einen Modulgehäuseboden bildende, bestückte Platine und eine diese Platine abdeckende und haltende Abdeckung, wobei diese Abdeckung so ausgebildet ist, dass mit ihr eine spannungsberührungslose Montage bzw. Demontage des Zusatzmoduls in das elektrische Gerät möglich ist.

Eine vorteilhafte Ausgestaltung der Erfindung sieht vor, dass zumindest die Kommunikationsschnittstelle im elektrischen Gerät galvanisch getrennt ausgeführt ist, z.B. mittels einer optischen Schnittstelle.

Die Platine weist entsprechend ihrem Bedarf Platinenanschlüsse für eine Gleichstromversorgung und/oder eine Wechselstromversorgung auf, wobei ihre Anschlussgegenstücke im elektrischen Gerät an oder durch eine Gehäusewand im Bereich der Ausnehmung zur Verfügung gestellt sind.

Ein Zusatzmodul für das erfindungsgemässe elektrische Gerät weist von aussen zugängliche Klemmenanschlüsse auf, die bedienbar sind, wenn das Zusatzmodul in der Ausnehmung angeordnet ist. Mit Vorteil ist eine Abdeckung einer Zusatzmodulplatine zumindest teilweise aus transparentem Kunststoff hergestellt, so dass mit dem Zusatzmodul eine Informationsanzeige bereitgestellt werden kann.

Weitere Vorteile der Erfindung ergeben sich aus den Ansprüchen und der folgenden detaillierten Beschreibung, in der bevorzugte Ausgestaltungen unter Bezugnahme auf die Zeichnung im einzelnen erläutert sind. Dabei zeigt

Fig. 1 eine perspektivische Darstellung eines efindungsgemässen elektrischen Geräts mit einem Zusatzmodul;

Fig. 2 das elektrische Gerät mit einer offenen Ausnehmung für das Zusatzmodul;

Fig. 3 a das Zusatzmodul von oben;

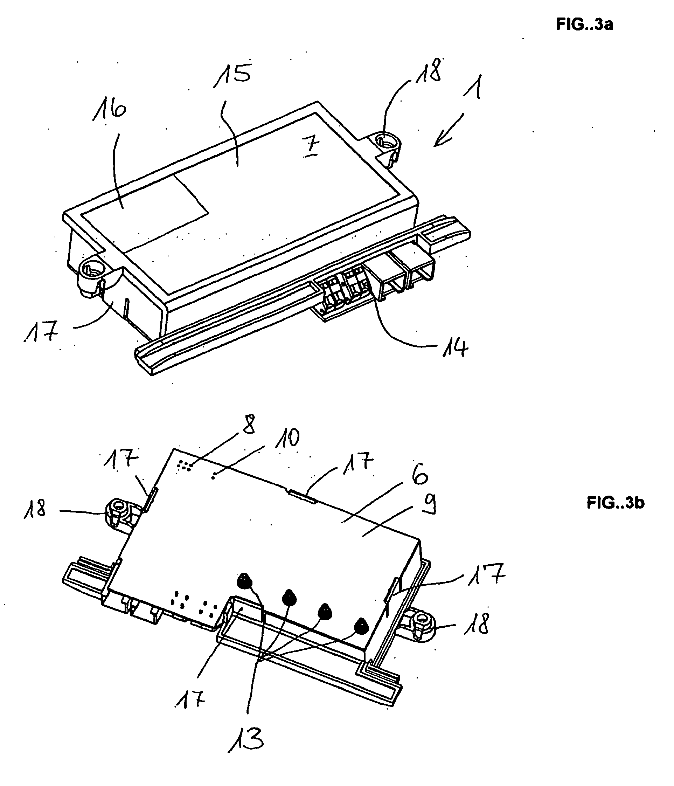

Fig. 3 b das Zusatzmodul von unten,

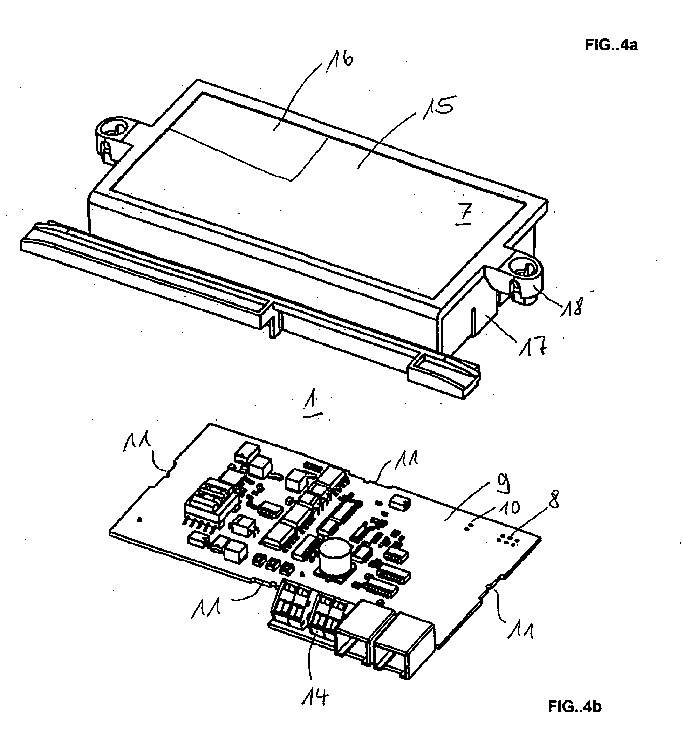

Fig. 4 a eine Abdeckung für ein Zusatzmodul, und

Fig. 4 b eine Platine des Zusatzmoduls.

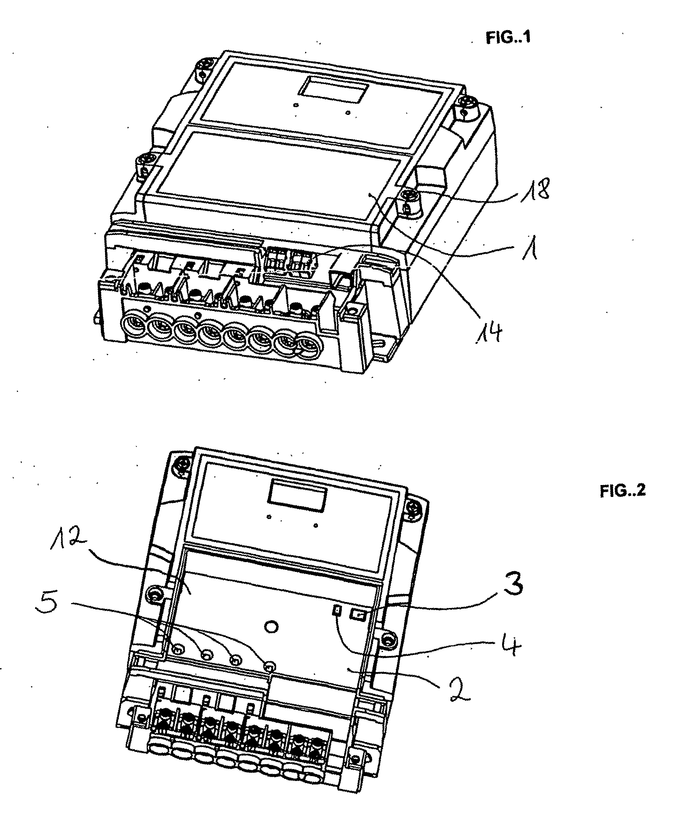

In Fig. 1 ist ein efindungsgemässes elektrisches Gerät gezeigt, dass mit einem Zusatzmodul 1 ausgestattet ist. Das elektrische Gerät besitzt Grundfunktionen eines Elektrizitätszählers, die hier nicht näher erläutert werden, da sie nicht Gegenstand der vorliegenden Erfindung sind. Im Übrigen ist die efindungsgemässe Ausgestaltung eines elektrischen Geräts zwar besonders vorteilhaft bei Zählern jeder Art, wie Elektrizitätszählern, Durchflusszählern, Wärmezählern und dergleichen, anwendbar aber nicht einschränkend. Das Zusatzmodul 1 in Fig. 1 ist so in das elektrische Gehäuse integriert, dass eine gemeinsame Oberfläche des ergänzten elektrischen Geräts entsteht. Das Zusatzmodul 1 ist durch Befestigungsmittel 18 mit dem elektrischen Gerät verbunden. Typischerweise ist das Zusatzmodul 1 mit dem elektrischen Gerät verschraubt und gegen unberechtigten Zugriff plombierbar. Das Zusatzmodul 1 weist Klemmenanschlüsse 14 auf, die im eingesetzten Zustand des Zusatzmoduls 1 bedienbar sind.

Fig. 2 zeigt das elektrische Gerät mit einer geöffneten - das heisst unverdeckten - Ausnehmung 2 für ein Zusatzmodul 1. An einer Wand 12 dieser Ausnehmung 2 sind eine Schnittstelle 3 für Daten und/oder Impulse und/oder analoge/digitale Ein- bzw. Ausgänge, ein Gleichstromanschluss 4 und ein Wechselstromanschluss 5 installiert. Die Schnittstelle 3 besteht entweder aus geeigneten elektrischen Kontaktanschlüssen oder aus einer optischen Schnittstelle. Da die Ausführungsform dieser Schnittstelle 3 nicht Gegenstand der vorliegenden Erfindung ist, wird hier nicht näher darauf eingegangen, sondern auf entsprechendes Wissen einschlägigen Fachpersonals verwiesen. Der Gleichstromanschluss 4 und der Wechselstromanschluss 5 sind gemäss entsprechender Vorschriften gestaltet und wahlweise Berührungskontakte oder Klemmkontakte umfassend. Mit Vorteil ist der Wechselstromanschluss 5 mittels versenkter Kontaktflächen im elektrischen Gerät ausgeführt. Wie weiter unten die Beschreibung zu Fig. 3b lehrt, erfolgt durch entsprechende Platinenanschlüsse für eine Wechselstromversorgung 13 an einer Platine 9 des Zusatzmoduls 1 eine federnd ausgestaltete Berührungskontaktverbindung mit den Wechselstromanschlüssen 5 des elektrischen Geräts.

Die Fig. 3a zeigt das Zusatzmodul 1 in einer perspektivischen Draufsicht und Fig. 3b die zugehörige Bodenansicht. Das Zusatzmodul 1 umfasst im wesentlichen eine einen Modulgehäuseboden 6 bildende, bestückte Platine 9, die mittels einer Anzahl Rastzungen 17 von einer Abdeckung 7 verschlossen gehalten wird. Die Abdeckung 7 ist vorteilhafterweise zumindest teilweise aus transparentem Kunststoff hergestellt, so dass mit entsprechender Bestückung (nicht gezeigt) der Platine 9 in einem Bereich einer Informationsanzeige 16 zugehörige Funktionen des Zusatzmoduls 1 angezeigt werden können.

Die Fig. 3b zeigt von dem Zusatzmodul 1 die Unterseite mit einer Vielzahl von Anschlüssen. Mit 8 ist eine weitere schnittstelle für Daten und/oder Impulse und/oder analoge/digitale Ein- bzw. Ausgänge bezeichnet, die mit der ersten Schnittstelle 3 im elektrischen Gerät korrespondiert. Des Weiteren sind auf der Platine 9 Platinenanschlüsse 10 für eine Gleichstromversorgung und Platinenanschlüsse 13 für eine Wechselstromversorgung angeordnet, die jeweils mit entsprechenden Anschlüssen des elektrischen Geräts korrespondieren, nämlich mit den Gleichstromanschlüssen 4 und dem Wechselstromanschlüssen 5 in Fig. 2.

Die Fig. 4a und Fig. 4b zeigen in Explosionsdarstellung das Zusatzmodul 1 zerlegt in eine bestückte Platine 9 und die zu ihr gehörige Abdeckung 7 mit den Rastzungen 17. Diese Rastzungen 17 der Abdeckung 7 greifen in entsprechende Ausnehmungen 11 der Platine 9 und verschliessen die Platine auf ihrer bestückten Seite.

Von besonderem Vorteil ist, dass ein erfindungsgemäss ausgestaltetes elektrisches Gerät in der Lage ist ein beliebiges Zusatzmodul 1 aufzunehmen und bedarfsgerecht nicht nur mit Informationen über eine Kommunikationsschnittstelle zu versorgen, sondern darüber hinaus für ein solches Zusatzmodul 1 eine entsprechende Speisung bereitzustellen. Somit ist das elektrische Gerät erstmals vollumfänglich "Plug and Play" fähig, wobei jedes Zusatzmodul 1 vollkommen spannungsberührungssicher an der Abdeckung 7 gehandhabt werden und in die Ausnehmung 2 eingesetzt oder aus ihre entnommen werden kann.

### Bezugszeichenliste

- 1: Zusatzmodul
- 2: Ausnehmung
- 3: erste Schnittstelle für Daten bzw. Impulse
- 4: Gleichstromanschlüsse
- 5: Wechselstromanschlüsse
- 6: Modulgehäuseboden
- 7: Abdeckung
- 8: weitere Schnittstelle für Daten bzw. Impulse
- 9: Platine
- 10: Platinenanschlüsse für eine Gleichstromversorgung
- 11: Ausnehmung
- 12: Wand der Ausnehmung 2
- 13: Platinenanschlüsse für eine Wechselstromversorgung
- 14: Klemmenanschlüsse
- 15: Oberseite
- 16: Informationsanzeige
- 17: Rastzunge

## Patentansprüche

1. Elektrisches Gerät, insbesondere Zähler mit einer Modulanschlussmöglichkeit for ein Zusatzmodul (1), welches in eine Ausnehmung (2) des elektrische Geräts einführbar ist, wobei das elektrische Gerät in der Ausnehmung (2) eine erste Schnittstelle (3) für Daten und/oder Impulse und/oder analoge/digitale Ein- bzw. Ausgänge zwecks Informationsübermittlung zu dem bzw. von dem Zusatzmodul (1) aufweist und darüber hinaus das elektrische Gerät zwecks Stromversorgung zu dem Zusatzmodul (1) in der Ausnehmung (2) eine Anzahl Gleichstromanschlüsse (4) und eine Anzahl Wechselstromanschlüsse (5) aufweist, wobei das Zusatzmodul (1) mit der ersten Schnittstelle (3) und der Anzahl Gleichstromanschlüsse (4) und/oder der Anzahl Wechselstromanschlüsse (5) durch Einsetzen in die Ausnehmung (2) unmittelbar in eine Wirkverbindung bringbar ist.
**dadurch gekennzeichnet,**
**dass** das Zusatzmodul (1) im wesentlichen aus einer einen Modulgehäuseboden (6) bildenden, bestückten Platine (9) und einer diese Platine (9) abdeckenden und haltenden Abdeckung (7) besteht, wobei diese Abdeckung (7) so ausgebildet ist, dass mit ihr eine spannungsberührungslose Montage bzw. Demontage des Zusatzmoduls (1) möglich ist.

2. Elektrisches Gerät nach Anspruch 1,
**dadurch gekennzeichnet,**
**dass** die Platine (9) eine weitere Schnittstelle (8) für Daten und/oder Impulse und/oder analoge/digitale Ein- bzw. Ausgänge aufweist, die mit der ersten Schnittstelle (3) des elektrischen Geräts kommuniziert.

3. Elektrisches Gerät nach Anspruch 2,
**dadurch gekennzeichnet,**
**dass** die erste und/oder die weitere Schnittstelle (3,8) galvanisch getrennt ausgebildet ist bzw. sind.

4. Elektrisches Gerät nach Anspruch 2,
**dadurch gekennzeichnet,**
**dass** die Platine (9) erste Platinenanschlüsse (10) für eine Gleichstromversorgung aufweist, die mit den Gleichstromanschlüssen (4) des elektrischen Geräts in Wirkverbindung stehen, wobei die Gleichstromanschlüsse (4) des elektrischen Geräts durch eine Wand (12) oder an einer Wand (12) der Ausnehmung (2) bereit gestellt sind.

5. Elektrisches Geräts nach einem der Ansprüche 2 bis 4,
**dadurch gekennzeichnet,**
**dass** die Platine (9) zweite Platinenanschlüsse (13) für eine Kontaktierung mit einer oder mehreren Wechselstromanschlüssen (5) des elektrischen Geräts aufweist, wobei die Wechselstromanschlüsse (5) durch eine Wand (12) oder an einer Wand (12) der Ausnehmung (2) bereit gestellt sind.

6. Elektrisches Gerät nach einem der vorherigen Ansprüche,
**dadurch gekennzeichnet,**
**dass** die Platine (9) eine Anzahl Klemmenanschlüsse (14) aufweist, die bedienbar sind, wenn das Zusatzmodul (1) in der Ausnehmung (2) angeordnet ist

7. Elektrisches Gerät nach einem der vorherigen Ansprüche,
**dadurch gekennzeichnet,**
**dass** die Abdeckung (7) zumindest teilweise aus einem transparenten Kunststoff besteht, sodass an einer Oberseite (15) der Abdeckung (7) eine optische Informationsanzeige (16) sichtbar ist.

## Claims

1. Electrical device, in particular counter, having a module connection option for an auxiliary module (1) which can be inserted into a recess (2) in the electrical device, with the electrical device having, in the recess (2), a first interface (3) for data and/or pulses and/or analogue/digital inputs and outputs for the purpose of transmitting information to or from the auxiliary module (1) and the electrical device also having a number of DC connections (4) and a number of AC connections (5) for the purpose of supplying power to the auxiliary module (1) in the recess (2), it being possible to directly operatively connect the auxiliary module (1) to the first interface (3) and the number of DC connections (4) and/or the number of AC connections (5) by inserting the said auxiliary module into the recess (2), **characterized in that** the auxiliary module (1) essentially comprises a populated printed circuit board (9), which forms a module housing base (6), and a cover (7) which covers and holds this printed circuit board (9), with this cover (7) being designed such that it is possible to install and remove the auxiliary module (1) using the cover without the risk of electric shock.

2. Electrical device according to Claim 1, **characterized in that** the printed circuit board (9) has a further interface (8) for data and/or pulses and/or analogue/digital inputs and outputs, this further interface communicating with the first interface (3) of the electrical device.

3. Electrical device according to Claim 2, **characterized in that** the first and/or the further interface (3, 8) are/is of DC-isolated design.

4. Electrical device according to Claim 2, **characterized in that** the printed circuit board (9) has first printed circuit board connections (10) for a DC power supply which is operatively connected to the DC connections (4) of the electrical device, with the DC connections (4) of the electrical device being provided by a wall (12) or on a wall (12) of the recess (2).

5. Electrical device according to one of Claims 2 to 4, **characterized in that** the printed circuit board (9) has second printed circuit board connections (13) for making contact with one or more AC connections (5) of the electrical device, with the AC connections (5) being provided by a wall (12) or on a wall (12) of the recess (2).

6. Electrical device according to one of the preceding claims, **characterized in that** the printed circuit board (9) has a number of terminal connections (14) which can be operated when the auxiliary module (1) is arranged in the recess (2).

7. Electrical device according to one of the preceding claims, **characterized in that** the cover (7) is at least partially composed of a transparent plastic, with the result that an optical information display (16) is visible on an upper face (15) of the cover (7).

## Revendications

1. Appareil électrique, en particulier compteur, comprenant une possibilité de raccordement de module pour un module auxiliaire (1), qui peut être incorporé dans un évidement (2) de l'appareil électrique, l'appareil électrique présentant, dans l'évidement (2), une première interface (3) pour des données et/ou des impulsions et/ou des entrées ou sorties analogiques/numériques afin de transmettre des informations vers ou depuis le module auxiliaire (1), l'appareil électrique présentant en outre, aux fins d'alimenter en courant le module auxiliaire (1), dans l'évidement (2) une pluralité de raccords de courant continu (4) et une pluralité de raccords de courant alternatif (5), le module auxiliaire (1) pouvant être directement amené en liaison fonctionnelle avec la première interface (3) et la pluralité de raccords de courant continu (4) et/ou la pluralité de raccords de courant alternatif (5) par insertion dans l'évidement (2),
**caractérisé en ce que**
le module auxiliaire (1) se compose essentiellement d'une platine (9) équipée, formant un fond de boîtier de module (6), et d'un recouvrement (7) recouvrant cette platine (9) et la retenant, ce recouvrement (7) étant réalisé de telle sorte qu'il permette un montage et un démontage sans contact de tension du module auxiliaire (1).

2. Appareil électrique selon la revendication 1,
**caractérisé en ce que**
la platine (9) présente une autre interface (8) pour des données et/ou des impulsions et/ou des entrées ou sorties analogiques/numériques, qui communique avec la première interface (3) de l'appareil électrique.

3. Appareil électrique selon la revendication 2,
**caractérisé en ce que**
la première et/ou l'autre interface (3, 8) est/sont réalisée(s) de manière séparée galvaniquement.

4. Appareil électrique selon la revendication 2,
**caractérisé en ce que**
la platine (9) présente des premiers raccords de platine (10) pour une alimentation en courant continu, qui sont en liaison fonctionnelle avec les raccords de courant continu (4) de l'appareil électrique, les raccords de courant continu (4) de l'appareil électrique étant fournis par une paroi (12) ou sur une paroi (12) de l'évidement (2).

5. Appareil électrique selon l'une quelconque des revendications 2 à 4,
**caractérisé en ce que**
la platine (9) présente des deuxièmes raccords de platine (13) pour une mise en contact avec un ou plusieurs raccords de courant alternatif (5) de l'appareil électrique, les raccords de courant alternatif (5) étant fournis par une paroi (12) ou sur une paroi (12) de l'évidement (2).

6. Appareil électrique selon l'une quelconque des revendications précédentes,
**caractérisé en ce que**
la platine (9) présente une pluralité de raccords à bornes (14) qui peuvent être utilisés quand le module auxiliaire (1) est disposé dans l'évidement (2).

7. Appareil électrique selon l'une quelconque des revendications précédentes,
**caractérisé en ce que**
le recouvrement (7) se compose au moins en partie d'un plastique transparent, de sorte qu'un affichage d'information optique (16) soit visible au niveau d'un côté supérieur (15) du recouvrement (7).
